# EUROPEAN PATENT SPECIFICATION

(11) **EP 2 402 100 B1**
(45) Date of publication and mention of the grant of the patent: **31.05.2017**
(21) Application number: 10746187.3
(22) Date of filing: 23.02.2010
(51) Int. Cl.: B23D 13/00, B28D 5/04, H01L 31/04

(54) **SLOTTING TOOL, AND THIN FILM SOLAR CELL SLOTTING METHOD AND SCRIBING DEVICE USING SAME**
SCHLITZWERKZEUG UND DÜNNSCHICHTSOLARZELLEN-SCHLITZVERFAHREN SOWIE BESCHRIFTUNGSVORRICHTUNG DAMIT
OUTIL DE RAINURAGE, ET PROCÉDÉ DE RAINURAGE DE CELLULE SOLAIRE À FILM MINCE ET DISPOSITIF DE TRAÇAGE UTILISANT CE DERNIER

(30) Priority: 24.02.2009 JP 2009040230; 08.12.2009 JP 2009278148
(43) Date of publication of application: 04.01.2012
(73) Proprietor: Mitsuboshi Diamond Industrial Co., Ltd., Suita-shi, Osaka 564-0044 (JP)
(72) Inventor: SOYAMA, Masanobu, Suita-city Osaka 564-0044 (JP)
(74) Representative: TBK
(86) International application number: PCT/JP2010/052704
(87) International publication number: WO 2010/098306

(56) References cited:
- JP-A- 10 118 806
- JP-A- 10 118 806
- JP-A- 10 328 922
- JP-A- 2002 094 089
- JP-A- 2005 014 116
- JP-U- 2 004 712
- US-A- 945 532
- US-A1- 2008 229 893

## Description

The present invention relates to a slotting tool, a slotting method and a scribing device using the slotting tool when an integrated thin film solar cell, such as a chalcopyrite compound-based integrated thin film solar cell, is manufactured.

Here, chalcopyrite compounds include CIGSS (Cu(In, Ga)(Se, S)₂) and CIS (CulnS₂) in addition to CIGS (Cu(In, Ga)Se₂).

Thin film solar cells using a chalcopyrite compound semiconductor as a light absorbing layer generally have an integrated structure where a number of unit cells are connected in series on a substrate.

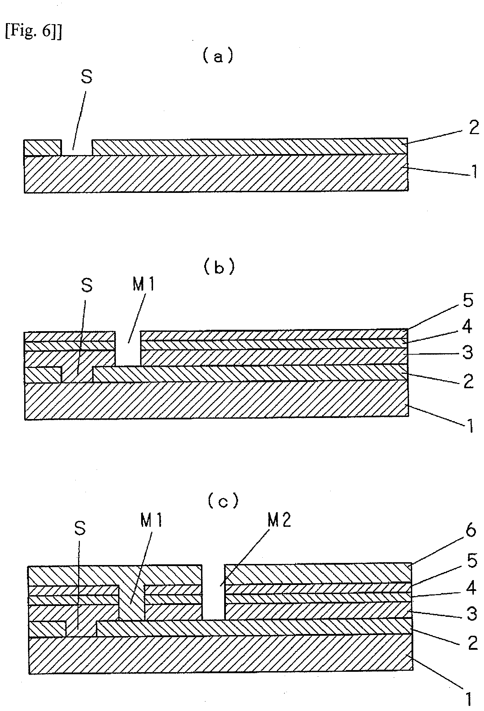

A conventional manufacturing method for a chalcopyrite compound-based integrated thin film solar cell is described below. Figs 6(a) to 6(c) are schematic diagrams showing the manufacturing steps for a CIGS thin film solar cell. First, as shown in Fig 6(a), an Mo electrode layer 2, which is to become a lower electrode on the + side, is formed on an insulating substrate 1 made of soda lime glass (SLG) or the like in accordance with a sputtering method, and after that a slot S for separating lower electrodes is created by carrying out a scribing process on the thin film solar cell substrate before a light absorbing layer is formed.

Next, as shown in Fig 6(b), a light absorbing layer 3 made of a compound semiconductor (CIGS) thin film is formed on the Mo electrode layer 2 in accordance with a vapor deposition method, a sputtering method or the like, on top of this a buffer layer 4 is formed of a ZnS thin film or the like for heterojunction in accordance with a CBD method (chemical bath deposition method), and on top of this an insulating layer 5 is formed of a ZnO thin film. Then, a slot M1 for a contact between electrodes, which reaches the Mo electrode layer 2, is created in accordance with a scribing process in the thin film solar cell substrate before a transparent electrode layer is formed at a location away from the slot S for separating lower electrodes by a predetermined distance to the side.

Next, as shown in Fig 6(c), a transparent electrode layer 6 made of a ZnO:Al thin film is formed on top of the insulating layer 5 as an upper electrode so as to provide a solar cell substrate with function layers required for power generation using photovoltaic conversion, and then a slot M2 for separating electrodes, which reaches the Mo electrode layer 2 in the lower portion, is created in accordance with a scribing process.

During the above described process for manufacturing an integrated thin film solar cell, a laser scribing method and a mechanical scribing method have been used as the technology for creating slots M1 and M2 for separating electrodes through a scribing process.

In accordance with a laser scribing method, as disclosed in Document 1 JP H11-312815 A, for example, a slot for separating electrodes is created through irradiation with a laser beam emitted by exciting an Nd:YAG crystal by means of a continuous discharge lamp, such as an arc lamp. In the case where a slot is created in a thin film solar cell substrate after the formation of a light absorbing layer in accordance with this method, however, there is a risk that the photovoltaic conversion properties of the light absorbing layer 3 may deteriorate due to the heat from the laser beam while scribing.

As disclosed in Documents 2 JP 2002-094089 A and 3 JP 2004-115356 A, for example, mechanical scribing methods relate to a technology for creating a slot for separating electrodes by moving the cutting edge of a slotting tool, such as a metal needle with the tip being tapered, while being pressed against the substrate with a predetermined amount of pressure. Currently, such a mechanical scribing method is widely used.

### Summary of the Invention

### Problem to Be Solved by the Invention

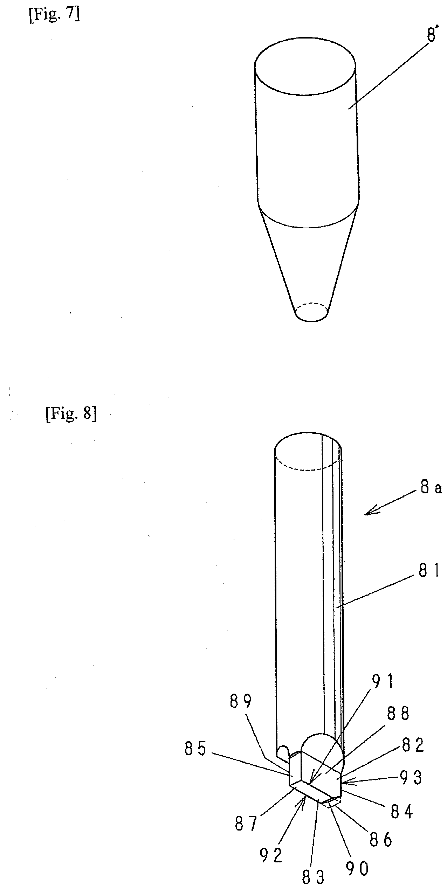

In the mechanical scribing methods as disclosed in Documents 2 JP 2002-094089 A and 3 JP 2004-115356 A, the cutting edge of a slotting tool is tapered as a needle, and strictly speaking, the tip to be pressed against thin film solar cells is approximately horizontally flat so as to provide a wide contact area. That is to say, as shown in Fig 7, the tip is in a truncated cone form. A slotting tool 8' having such a form is moved in the direction Y along a line to be scribed while being pressed against a thin film (any type of functional layer, such as an upper or lower electrode or a light absorbing layer) on a thin film solar cell substrate in which a slot is to be created, and thus a slot is created.

Since a slotting tool with the tip portion being in a truncated cone form is used so as to provide a large contact area with the thin film, a slot can be created relatively stably. Meanwhile, the thin film can be greatly and irregularly peeled due to friction resistance through the large contact area and an unnecessary portion may be removed, which may lead to such a problem that the properties and the yield of the solar cell may lower.

It is necessary to make the degree of peeling of a thin film constant, particularly in order to make the quality of the product (efficiency in photovoltaic conversion and the like) fit its design and in order to make the reproducibility high by keeping the width of the scribe line constant. In order to do so, the degree of peeling can be adjusted to a certain extent by adjusting the load under which the cutting edge is pressed in accordance with the properties of the thin film. However, the pressure against the surface of the thin film changes uniformly, and thus fine adjustment is very difficult.

In addition, the above described cutting edge of the slotting tool is in a truncated cone form having a tapered surface. Accordingly, in the case where the cutting edge that has been worn down or chipped is ground, the diameter of the cutting edge may increase, and as a result the width of the scribed slot may be greater than that before grinding. Therefore, the same cutting edge cannot be used over a long period of time or repeatedly, and thus there is a problem that it is wasteful.
Document JP 10 118 806 A discloses a method and a tool according to the preamble of claims 1 and 4 respectively.

Thus, it is the object of the present invention to provide a slotting tool with which a slot with a constant width can be created and products can be processed while keeping the quality, such as efficiency in photovoltaic conversion, uniform and with a high yield when slots for separating electrodes are created in a chalcopyrite compound-based integrated thin film solar cell substrate (for example, a precursor before the formation of a transparent electrode) and other integrated thin film solar cells, or slots for a contact between upper and lower electrodes are created in any type of functional layer, such as a light absorbing layer formed between upper and lower electrodes.
The object of the invention is achieved by a slotting method according to claim 1, a slotting tool according to claim 4 and a scribing device according to claim 9, respectively. Advantageous embodiments are carried out according to the dependent claims.

In order to achieve the above described object, the slotting tool for an integrated thin film solar cell according to the present invention is formed of: a body in rod form; and a cutting edge region formed at a tip of the body, wherein the cutting edge region is formed of a long, rectangular bottom, a front surface and a rear surface which rise from the short sides of the bottom, and a pair of sides, left and right sides, which rise at a right angle from the long sides of the bottom and are parallel to each other, and the corner formed of either a front or rear side and the bottom is used as a cutting edge.

In addition, in order to achieve the above described object, in accordance with the method for slotting an integrated thin film solar cell according to the present invention, a slotting tool is moved over an integrated thin film solar cell substrate along a line to be scribed on the above described solar cell substrate with the cutting edge of the slotting tool being pressed against the above described solar cell substrate so that a scribe line is created on the above described solar cell (for example, any type of functional layer at least including a light absorbing layer, in particular any functional layer that includes at least a light absorbing layer of the precursor before the formation of a transparent electrode layer), wherein the above described slotting tool comprises: a body in rod form; and a cutting edge region formed at a tip of the body, wherein the cutting edge region is formed of a long, rectangular bottom, a front surface and a rear surface which rise from the short sides of the bottom, and a pair of sides, left and right sides, which rise at a right angle from the long sides of the bottom and are parallel to each other, and the corner formed of either a front or rear side and the bottom is used as a cutting edge, and the long axis of the rectangular bottom is in the direction in which the above described slotting tool is moved, and the above described slotting tool is inclined in the direction in which the above described slotting tool is moved so that the angle formed between the front or rear surface of the cutting edge region and the surface of the solar cell to be processed is in a range from 50 degrees to 80 degrees, preferably from 65 degrees to 75 degrees.

### Effects of the Invention

The slotting tool according to the present invention makes it possible to create a slot with a constant width when a slot for separating electrodes is created in an integrated thin film solar cell, or a slot for a contact between upper and lower electrodes is created in any type of functional layer, such as a light absorbing layer formed between upper and lower electrodes, and thus the yield increases. In the case where the cutting edge is worn down, the cutting edge can be repaired by grinding the bottom and the front or rear surface, if necessary. In particular, the left and right sides of the cutting edge portion are parallel to each other, and therefore the width between the left and right side of the blade does not change even if the bottom is ground. As a result, the width of the scribed slot can be kept the same as that before grinding.

Furthermore, in the case where two cutting edges are formed at the front and rear corners of the slotting tool, the direction in which the tool is attached is changed when one cutting edge is worn down or broken so that the other cutting edge can be used as a new cutting edge.

In accordance with the method for manufacturing an integrated thin film solar cell according to the present invention, a slotting tool in such a form that cutting edges are formed at the corners between the bottom and the front surface as well as between the bottom and the rear surface is used for patterning, and therefore the front or rear surface of the slotting tool is inclined relative to the substrate in the direction in which the slotting tool is moved so that the cutting edges at the corners make contact with the substrate through linear contact, which is close to point contact, and thus the thin film can be peeled smoothly. The front or rear surface of the cutting edge portion of the slotting tool is inclined towards the direction in which the slotting tool is moved in such a manner that the angle between the front or rear surface and the upper surface of the substrate is within a range from 50 degrees to 80 degrees, preferably from 65 degrees to 75 degrees, and thus a linear and clean scribe line can be created without interruptions due to the bouncing of the cutting tool when it rides on shavings of the film (in the case where the angle of inclination is smaller than the above described set range of values) or without irregular peeling of the thin film due to a high load for pressing (in the case where the angle of inclination is greater than the above described set range of values).

The angle of the cutting edges formed between the bottom and the front surface as well as between the bottom and the rear surface of the slotting tool is a right angle. When a cutting edge that has been worn down is ground, it can be ground at a right angle relative to the axis of the body so that the bottom and the front and rear surfaces form right angles, and therefore grinding becomes easy.

It is preferable for the slotting tool to be formed of a hard metal or diamond.

This makes it possible for the life of the tool to be long with little deformation, and therefore a scribing process with high precision is possible over a long period of time.

### Brief Description of the Drawings

Fig 1 is a perspective diagram showing a scribing device for an integrated thin film solar cell according to one embodiment of the present invention;
Fig 2 is a perspective diagram showing the slotting tool according to the present invention;
Fig 3 is a diagram showing an enlargement of the bottom of the above described slotting tool;
Figs 4(a) to 4(c) are schematic diagrams showing the angles of inclination at which the slotting tool according to the present invention is attached and the corresponding states of the solar cell substrate on which a scribe line is created;
Fig 5 is a diagram showing the comparison of the states of the solar cell substrate in which scribe lines are created using a conventional slotting tool and the slotting tool according to the present invention;
Figs 6(a) to 6(c) are schematic diagrams showing the steps of manufacturing a general CIGS-based thin film solar cell;
Fig 7 is a perspective diagram showing an example of a conventional slotting tool;
Fig 8 is a perspective diagram showing the slotting tool according to another embodiment of the present invention;
Fig 9 is a perspective diagram showing an enlargement of the bottom of the slotting tool in Fig 8;
Fig 10 is a diagram showing an enlargement of the bottom of the slotting tool in Fig 8;
Figs 11(a) and 11(b) are diagrams showing the state of a cutting edge portion during scribing;
Fig 12 is a perspective diagram showing the slotting tool; and
Fig 13 is a perspective diagram showing an enlargement of the bottom of the slotting tool in Fig 12.

### Best Mode for Carrying Out the Invention

### (First Embodiment)

In the following, the present invention is described in detail in reference to the drawings showing the preferred embodiments.

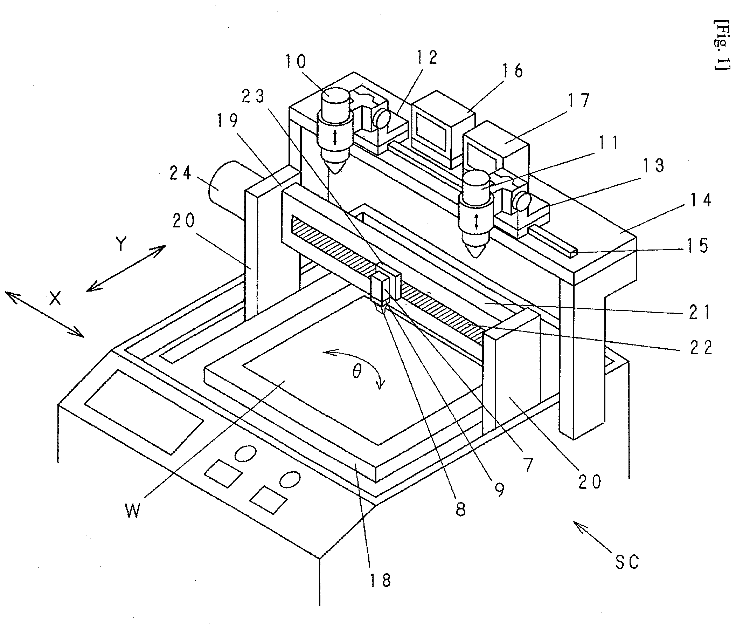

Fig 1 is a perspective diagram showing a scribing device SC for an integrated thin film solar cell using the slotting tool according to an embodiment of the present invention. The scribing device SC is provided with a table 18 which is moveable in the lateral direction (direction Y) and rotatable by 90 degrees and by an angle θ in the horizontal plane, where the table 18 basically forms a means for holding a solar cell substrate W.

Abridge 19 that goes over the table 18 is formed of supports 20 and 20 on both sides of the table 18 and a guide bar 21 that runs in the direction X. A holder support 23 is attached so as to be moveable along the guide 22 formed on the guide bar 21 and moves in the direction X when the motor 24 is driven.

The holder support 23 is provided with a scribing head 7, and a holder 9 for holding a slotting tool 8 that scribes the surface of the thin film on a solar cell substrate W mounted on the table 18 is provided to the bottom of the scribing head 7. The angle at which the holder 9 is attached to the scribing head 7 can be adjusted, and the angle between the slotting tool 8 and the solar cell substrate W can be adjusted by adjusting this angle of attachment.

In addition, cameras 10 and 11 are respectively provided to bases 12 and 13, which are moveable in the directions X and Y. The bases 12 and 13 move along the guide 15 that runs in the direction X on top of a support 14. The cameras 10 and 11 can be manually operated in order to be moved upwards and downwards so that the focus of images can be adjusted. The images taken by the cameras 10 and 11 are displayed on monitors 16 and 17.

An alignment mark for positioning is provided on the surface of the solar cell substrate W mounted on the table 18, and the position of the solar cell substrate W can be adjusted by taking images of the alignment mark with cameras 10 and 11. Concretely, images of the alignment mark on the surface of the solar cell substrate W supported by the table 18 are taken with cameras 10 and 11 so that the location of the alignment mark is identified. On the basis of the identified location of the alignment mark on the surface of the solar cell substrate W, the direction of the misalignment when the solar cell substrate W is mounted is detected, and the misalignment is rectified by rotating the table 18 by an appropriate angle.

Whenever the table 18 is moved in the direction Y by a predetermined pitch, the scribing head 7 is lowered so that the cutting edge of the slotting tool 8 is pressed against the surface of the solar cell substrate W, and the scribing head 7 is moved in the direction X in this state, and thus the surface of the solar cell substrate W is scribed in the direction X. In the case where the surface of the solar cell substrate W is scribed in the direction Y, the table 18 is rotated by 90 degrees, and then the same operation as in the above is carried out.

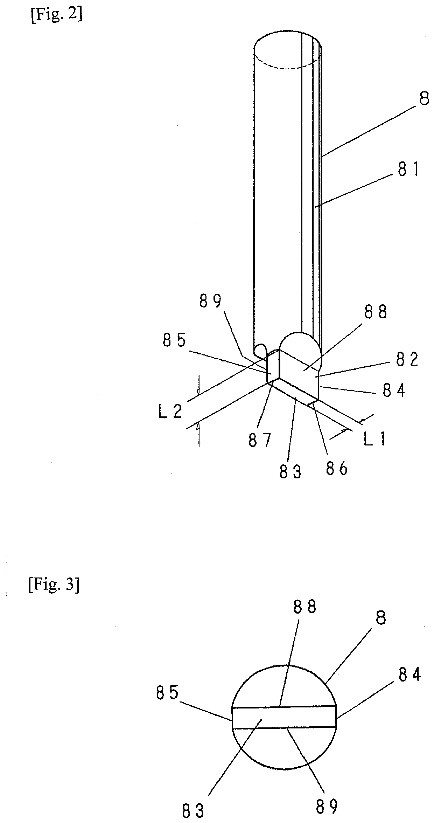

Figs 2 and 3 show the slotting tool 8 used in the present invention. Fig 2 is a perspective diagram as viewed from the bottom, and Fig 3 is a diagram showing an enlargement of the bottom of the slotting tool 8. This slotting tool 8 has a body 81 in cylindrical form, which basically becomes an attachment portion to the scribing head 7, and a cutting edge region 82 integrally formed in this tip portion through a discharging process or the like, and is made of a hard material, such as a hard metal or diamond. The cutting edge region 82 has a rectangular bottom 83, a front surface 84 and a rear surface 85 that rides at a right angle from the short sides of the bottom 83, and the left and right sides 88 and 89 that ride at a right angle from the long sides of the bottom 83 are parallel to each other. The corners formed between the bottom 83 and the front surface 84 as well as between the bottom 83 and the rear surface 85 provide cutting edges 86 and 87, respectively.

It is preferable for the width L1 between the left and right of the bottom 83 to be 50 µm to 60 µm, but it is possible for it to be 25 µm to 80 µm in accordance with the width of the scribed slot, if necessary. In addition, it is preferable for the effective height of the cutting edge region 82, that is to say, the height L2 of the left and right sides 88 and 89 as well as the front and rear surfaces 84 and 85 of the cutting edge region, to be approximately 0.5 mm. Furthermore, it is preferable for the diameter of the body 81 in cylindrical form to be approximately 2 mm to 3 mm. Here, the body 81 of the slotting tool 8 is not limited to a cylindrical form, and it is possible for it to be quadrilateral or polygonal in the cross section.

In the case where the above described slotting tool 8 is used for processing, the slotting tool 8 is attached to the scribing head 7 in such a state that the long axis of the bottom 83 of the cutting edge region 82 is directed in the direction in which the tool moves and the front surface 84 or the rear surface 85 of the cutting edge portion 82 is inclined by a predetermined angle relative to the solar cell substrate W. In this case, it is preferable for the angle of inclination to be in a range from 50 degrees to 80 degrees, and it is more preferable for it to be in a range from 65 degrees to 75 degrees.

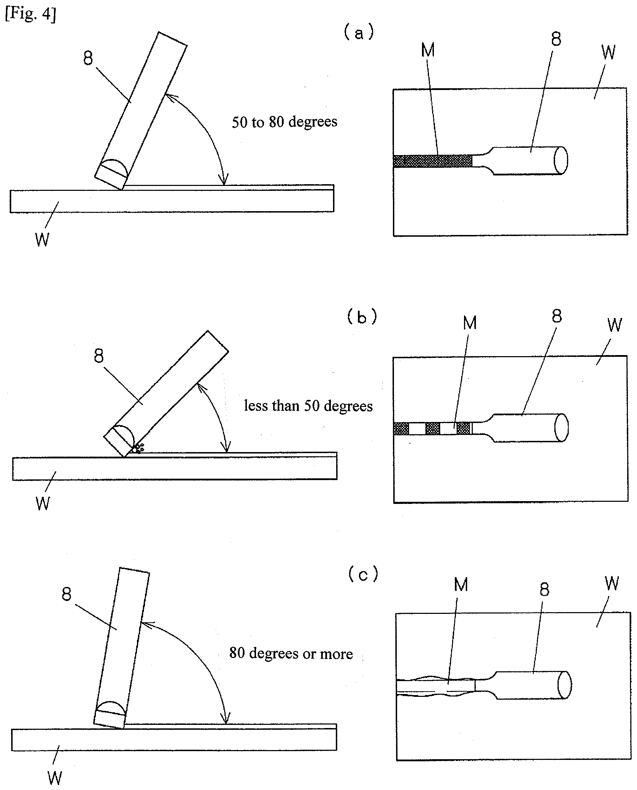

Figs 4(a) to 4(c) are schematic diagrams showing the results of the experiment of slotting a solar cell substrate W using a slotting tool 8 in terms of the relationship between the angle at which the slotting tool 8 was attached and the state of the processed solar cell substrate W.

Fig 4(a) shows the results of scribing when the slotting tool 8 was attached at a preferable angle of inclination in a range from 50 degrees to 80 degrees or in a more preferable range from 65 degrees to 75 degrees. The slot M created in the solar cell substrate W was linear and clear along the scribe line without extra peeling.

Fig 4(b) shows the results of scribing when the slotting tool 8 was attached at an angle of inclination of less than 50 degrees. The cutting edge of the slotting tool 8 rode on shavings of the film and bounced, and as a result the processed slot M had an interruption.

Fig 4(c) shows the results of scribing when the slotting tool 8 was attached at an angle of inclination that exceeded 80 degrees. The processed slot M had irregular peeling of the thin film due to the high load for pressing the slotting tool 8.

According to the present invention, the front surface 84 or the rear surface 85 of the slotting tool 8 is inclined in the direction in which the slotting tool 8 moves relative to the solar cell substrate W so that the corner formed between the front surface and the bottom surface or between the rear surface and the bottom, that is to say, the cutting edge 86 or the cutting edge 87, makes contact with the solar cell substrate W through line contact, which is close to point contact, and thus the thin film can be peeled smoothly. In particular, the slotting tool 8 is inclined in the direction in which the slotting tool 8 moves so that the angle between the front surface 84 or the rear surface 85 in the cutting edge region and the upper surface of the substrate W is within a range from 50 degrees to 80 degrees, preferably from 65 degrees to 75 degrees, and thus it becomes possible to create a linear and clean scribe line without interruptions due to the bouncing of the cutting tool when it rides on shavings of the film or without irregular peeling of the thin film due to a high load for pressing.

In addition, the slotting tool 8 has two cutting edges 86 and 87 in the front and rear corners, and therefore the direction in which the slotting tool 8 is attached is changed when one cutting edge is worn down or broken so that the other cutting edge can be used as a new cutting edge. Furthermore, the bottom 83 as well as the front and rear surfaces 84 and 85, if necessary, can be ground so as to repair the cutting edges in the case where the two cutting edges are worn down.

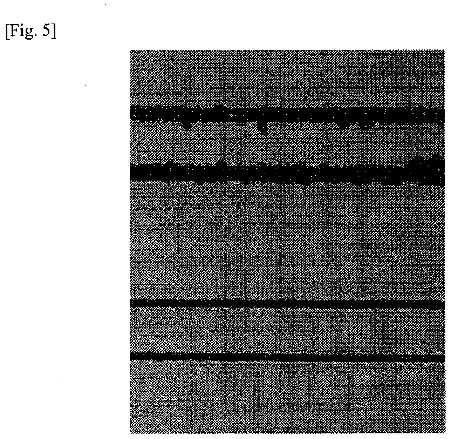

Fig 5 is an image where scribe lines created using a conventional slotting tool and scribe lines created using the slotting tool according to the present invention are compared. In the case where the slotting tool according to the present invention was used for scribing at an angle of inclination in a range from 65 degrees to 75 degrees, it was obvious that clean scribe lines with a constant width were created in comparison with the prior art.

Though in the above described embodiment the scribing process was carried out by moving the scribing head 7 in the direction X, the same scribing process is possible as long as either the scribing head 7 or the solar cell substrate W moves relative to the other. The scribing head 7 may be moved in the direction X or Y with the solar cell substrate W being in a fixed state, or only the solar cell substrate W may be moved in the direction X or Y without moving the scribing head 7.

Though a representative embodiment of the present invention is described in the above, the present invention is not necessarily limited to the structure in the above described embodiment and may be modified. For example, the angle of the cutting edges formed between the bottom and the front surface as well as between the bottom and the rear surface may be slightly obtuse, though a right angle is preferable as described in the above embodiment.

### (Second Embodiment)

Next, a slotting tool that is a modification of that of the first embodiment is described. As described in reference to Figs 4(a) to 4(c), the slotting tool 8 shown in Figs 2 and 3 is inclined when scribing so that the angle formed between the front surface 84 of the slotting tool 8 and the surface to be processed (scribing angle) is within an appropriate angle range, and thus a continuous slot with a constant width can be created.

In the case where the slotting tool 8 is new, however, the thin film adjacent to the slot sometimes peels, causing the width of the slot to be partially wider even when the scribing angle is set to an appropriate value for use. Furthermore, Mo films tend to scratch relatively easily. In the case where the slotting tool 8 is not new, a similar problem arises once in a while.

Thus, the slotting tool 8 is further improved, and a slotting tool having such a structure that a slot with a constant width can be created stably while preventing the thin film adjacent to the slot from being peeled and the film in the layer below the thin film to be slotted is hardly scratched is prepared.

The slotting tool according to the second embodiment of the present invention is made of: a body in rod form; and a cutting edge region in rectangular parallelepiped form formed at a tip of the body, wherein the cutting edge region is formed of five planes: a rectangular bottom surrounded by a pair of short sides and a pair of long sides; front and rear surfaces rising at a right angle relative to the bottom from the two short sides of the bottom; and left and right sides rising at a right angle relative to the bottom from the two long sides of the bottom, cutting edges in the longitudinal direction are formed at the corner between the front surface and the right side as well as at the corner between the front surface and the left side, a cutting edge in the lateral direction is formed at the corner between the bottom and the front surface, and the corner between the bottom and the right side as well as the corner between the bottom and the left side are rounded.

Thus, the slotting tool according to the present invention is used for slotting in such a manner that the slotting tool is inclined in the direction in which the slotting tool moves so that the cutting edge in the corner between the front surface and the bottom is made to make contact with a surface to be processed for scribing in such a state as being pressed.

In the slotting tool according to the second embodiment, the corner between the bottom and the right side and the corner between the bottom and the left side are rounded, and thus these corners are not sharp enough to peel the thin film when these corners make contact with the thin film during scribing, and therefore a clean linear slot can be created.

Concretely, the thin film can be completely prevented from being irregularly peeled (see Fig 4(c)), which would sometimes occur when these corners make contact with the thin film.

In the above described slotting tool according to the second embodiment, the corner between the bottom and the front surface may have an inclined surface. The slotting tool has an inclined surface from the beginning, and thus the inclined surface is pressed against the surface to be processed for scribing from the first use. The slotting tool with an inclined surface being created is similar to a slotting tool which did not originally have an inclined surface (see Fig 2) and is continuously used for a while so as to be in such a state that the corner between the bottom and the front surface is worn down. Accordingly, the slotting tool can be used for scribing from the beginning in the same state as that of the slotting tool that has been worn down. Concretely, a cutting edge that is too sharp may locally apply pressure to a surface to be processed and there is a risk that the Mo film may be damaged, and the inclined surface can prevent the pressure from being concentrated in a local point.

In addition, it is preferable for the angle formed between the inclined surface and the bottom of the slotting tool according to the second embodiment to be within a range from 10 degrees to 40 degrees. In the case where the angle formed between the inclined surface and the bottom is within this range, the angle formed between the front surface and the surface to be processed (scribing angle) is between 50 degrees (the angle formed between the inclined surface and the bottom is 40 degrees) and 80 degrees (the angle formed between the inclined surface and the bottom is 10 degrees) when the inclined surface of the slotting tool is made to make contact with the surface to be processed, and thus the angle can be set to be in such a range that a clean scribing process is possible as described in reference to Fig 4(a).

In addition, in the slotting tool according to the second embodiment, a cutting edge in the longitudinal direction may be formed in the corner between the rear surface and the right side as well as in the corner between the rear surface and the left side, and at the same time a cutting edge in the lateral direction may be formed in the corner between the rear surface and the bottom.

In the case where one side is broken or greatly worn down, the cutting edge can be switched with the other for continuous use of the slotting tool by switching the front and rear surfaces.

Here, an inclined surface may be created in the corner between the bottom and the rear surface. When an inclined surface is created in the corner between the bottom and the rear surface, the slotting tool is in the same state as being worn down when scribing in the case where the front and the rear are switched, and as a result the quality of the process can be prevented from changing over time.

In the following, the second slotting tool according to the present invention is described in detail in reference to the drawings.

The scribing device SC using the second slotting tool can be the same scribing device as described in reference to Fig 1 according to the first embodiment, and therefore the same symbols are attached to the same components and the same descriptions are not repeated.

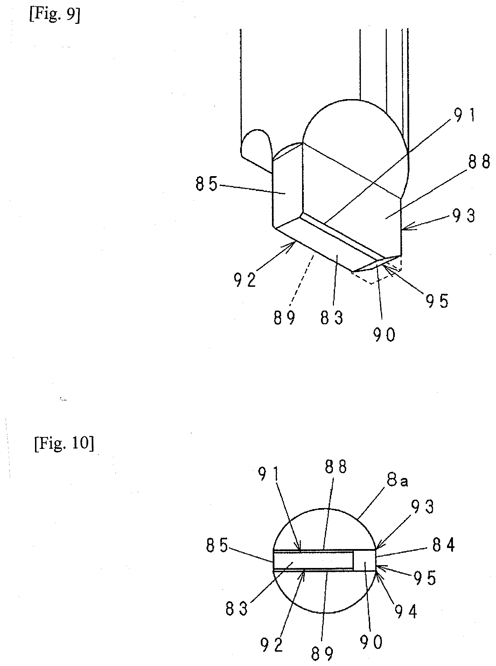

Next, the slotting tool according to the present invention that is to be attached to a scribing device is described. Figs 8 to 10 are diagrams showing the slotting tool 8a according to one embodiment of the invention, where Fig 8 is a perspective diagram as viewed from the bottom, Fig 9 is a perspective diagram showing an enlargement of the bottom, and Fig 10 is a diagram showing an enlargement of the bottom. The same symbols are attached to the same components as those of the slotting tool 8 that is described in reference to Fig 2.

This slotting tool 8a is formed of a body 81 in cylindrical form, which is an attachment portion to the scribing head 7, and a cutting edge region 82 in rectangular parallelepiped form, which is integrally formed with the tip portion of the body 81 through discharge processing or the like and is made of a hard material, such as a hard metal or diamond.

The cutting edge region 82 has a long rectangular bottom 83 surrounded by a pair of short sides and a pair of long sides, a front surface 84 and a rear surface 85 which rise from the short sides of the bottom 83 so as to be perpendicular to the bottom (in the state before the below described inclined surfaces 90 and 96 are created), and a left side 88 and a right side 89 which rise from the long sides of the bottom 83 so as to be perpendicular to the bottom and are parallel to each other.

The corner between the bottom 83 and the front surface 84 in the cutting edge region 82 is rounded and an inclined surface 90 is created. When a solar cell substrate is slotted, this inclined surface 90 is made to make contact with the surface to be processed of the solar cell substrate, and in this state the slotting tool 8a is moved in the direction parallel to the left side 88 and the right side 89 so that the surface to be processed of the solar cell substrate is scribed. The main reason why the inclined surface 90 is provided is that the surface is scribed with the slotting tool from the beginning in the same state as being worn down. Another reason is to prevent pressure from being locally concentrated since a cutting edge that is too sharp may make pressure be applied locally, and there is a risk that the Mo film may be damaged. Here, though the inclined surface 90 is large in the figures for the sake of convenience of the description, the inclined surface 90 may be smaller than this as long as the inclined surface 90 can be made to make contact with the surface to be processed for scribing. Concretely, the length of the inclined surface 90 between the bottom and the front surface (width of the rounded corner) is approximately 3 µm to 20 µm.

The slotting tool 8a may be moved in the direction parallel to the left side 88 and the right side 89 so as to scribe the surface to be processed of the solar cell substrate in such a state that the corner between the bottom 83 and the front surface 84 of the cutting edge region 82 is made to make contact with the surface to be processed in the case there is no inclined surface 90. In this case, there is a risk that the Mo film may be damaged when the slotting tool 8a is used for the first time, but the corner between the bottom 83 and the front surface 84 is worn down after scribing has been carried out several times, and the risk of the Mo film being damaged is eliminated. Therefore, when the slotting tool is replaced with a new one, Mo metal plates or solar cell substrates that are defective products may be used so as to carry out scribing for several times, and the corner between the bottom 83 and the front surface 84 may be intentionally worn down before the slotting tool is used for processing in order to mass produce products.

In addition, the slotting tool 8a has a rounded corner 91 between the bottom 83 and the left side 88 and a rounded corner 92 between the bottom 83 and the right side 89. It is preferable for the corners to be rounded in accordance with a chamfering process, but it may be a rounding process. The width of the rounded corners (length between the bottom and the left side as well as the length between the bottom and the right side) is approximately 3 µm to 8 µm.

Meanwhile, the corner 93 between the front surface 84 and the left side 88 and the corner 94 between the front surface 84 and the right side 89 are finished as sharp corners without being rounded, and thus are used as cutting edges in the longitudinal direction (vertical direction).

In addition, the inclined surface 90 forms an angle of 10 degrees to 40 degrees with the bottom 83, and preferably forms an angle of 15 degrees to 25 degrees. That is to say, the scribing angle α formed between the front surface 84 and the inclined surface 90 is within a range from 50 degrees to 80 degrees, preferably within a range from 65 degrees to 75 degrees, in the state where the inclined surface 90 makes contact with the surface to be processed. This scribing angle is within a range such that an appropriate scribing process is possible, as described in reference to Fig 4 (a).

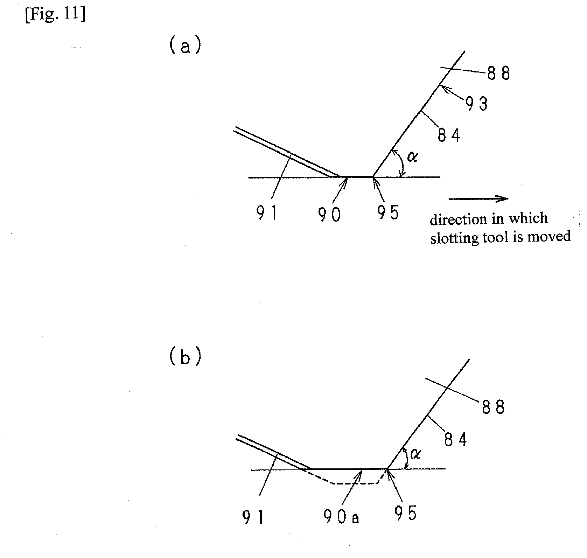

Next, a change in the cutting edge of the slotting tool 8a according to the present invention over time is described. Figs 11(a) and 11(b) are diagrams showing the state of a cutting edge portion during scribing, and Fig 11(a) shows a state when the slotting tool 8a is new and Fig 11(b) shows a state after it has been used for a while.

The inclined surface 90 is worn down as the number of times of scribing increases, and the scribing ends up with the use of the inclined surface 90a of which the length has been increased between the front and rear in comparison with the inclined surface 90 when the slotting tool 8a is new. Even though the inclined surface 90 has changed to the inclined surface 90a, the length of the surface contact has slightly changed and the effects on the surface to be processed have not been greatly changed. In addition, the inclined surface 90a has the same width between the left and right as the inclined surface 90 and is parallel to the inclined surface 90, and therefore a stable scribing process can be carried out such that the line width and the scribing angle α are the same even after the slotting tool has been worn down.

The angle 91 between the bottom 83 and the left side 88 and the angle 92 between the bottom 83 and the right side 89 are greatly rounded, and therefore the bottom 83 moves away from the surface to be processed in the case where the slotting tool 8a is inclined for scribing, which has so far been considered to barely affect the quality of processing. Therefore, the corners are made in a sharp state without being rounded. However, the quality of processing is increased when the corners 91 and 92 are rounded. In particular, films are barely peeled in such a manner that used to occasionally happen. Thus, films are barely peeled irregularly when the corners 93 and 94 are kept sharp and other corners 91 and 92 are rounded.

Though the corners 93 and 94 are chamfered as well, the quality of processing deteriorates, thereby causing films to be peeled. The results are summarized in Table 1.

**[Table 1]**

| Rounding of corners 91, 92 | Rounding of corners 93, 94 | Quality of processing |
|---|---|---|
| No | No | Film is peeled (Fig 11(c)) |
| Yes | Yes | Film is peeled (Fig 11(c)) |
| Yes | No | Good (Fig 11(a)) |

That is to say, excellent quality of processing can be gained when the corners 93 and 94 are not rounded and are kept as sharp cutting edges, while the corners 91 and 92 are rounded.

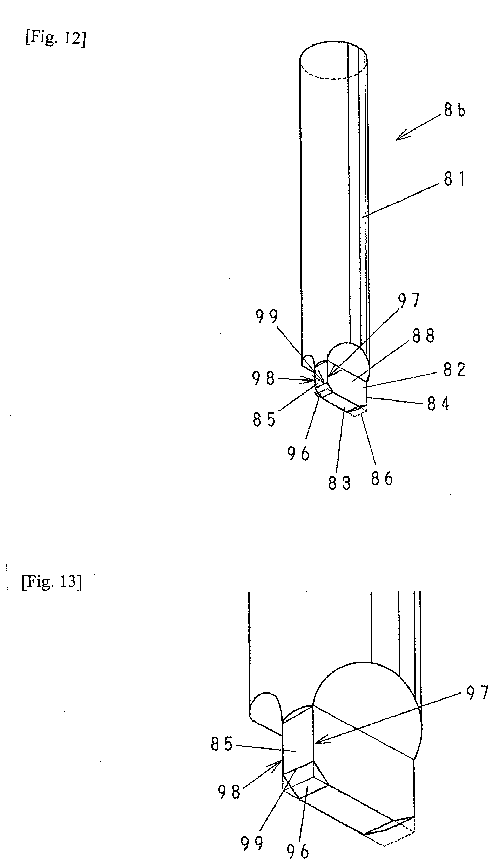

Fig 12 is a perspective diagram showing a slotting tool 8b not according to the invention, and Fig 13 is a perspective diagram showing an enlargement of the bottom thereof. Here, the same symbols are attached to the same components as in the slotting tool 8a shown in Figs 8 to 10, and the same descriptions are not repeated.

According to the present embodiment, not only the corners on the front surface 84 side but also the corners 97 and 98 on the rear surface 85 side are not rounded and are finished as being sharp so as to provide cutting edges in the longitudinal direction. Furthermore, an inclined surface 96 is created so that the corner 99 between the inclined surface 96 and the rear surface 85 is a cutting edge in the lateral direction.

As a result, a scribing process is possible when the slotting tool moves towards the front surface 84 side, and in addition a scribing process is possible when the slotting tool moves towards the rear surface 85 side when the front and rear are switched, and thus the life of the slotting tool can be doubled.

Though representative embodiments of the present invention are described in the above, the present invention is not necessarily limited to the structure in the above described embodiments, and appropriate modifications and alterations are possible as long as an object of the present invention is achieved and the scope of claims.

### Industrial Applicability

The present invention can be applied to a slotting tool used for the manufacture of an integrated thin film solar cell using a chalcopyrite compound-based semiconductor film, for example.

### Explanation of Symbols

- W: solar cell substrate
- 7: scribing head
- 8, 8a, 8b: slotting tool
- 81: body
- 82: cutting edge region
- 83: bottom
- 84: front surface
- 85: rear surface
- 86: cutting edge
- 87: cutting edge
- 88: left side
- 89: right side
- 90, 96: inclined surface
- 91, 92: corner (rounded)
- 93, 94, 95: corner (cutting edge)
- 97, 98, 99: corner (cutting edge)

## Claims

1. A method for slotting an integrated thin film solar cell, according to which a slotting tool (8, 8a, 8b) is moved over an integrated thin film solar cell substrate (W) along a line to be scribed on said solar cell substrate (W) with the cutting edge (86, 87) of the slotting tool (8, 8b, 8c) being pressed against said solar cell substrate (W) so that a scribe line is created on said solar cell, wherein said slotting tool (8, 8b, 8c) comprises: a body (81) in rod form; and a cutting edge region (82) formed at a tip of the body, wherein the cutting edge region (82) is formed of a long, rectangular bottom (83), a front surface (84) and a rear surface (85) which rise from the short sides of the bottom (83), and a pair of sides, left and right sides (88, 89), which rise at a right angle from the long sides of the bottom (83) and are parallel to each other, and the corner (93, 94, 95, 97, 98, 99) formed of either a front or rear side and the bottom (83) is used as a cutting edge (86, 87), and
the long axis of the rectangular bottom (83) is in the direction in which said slotting tool (8, 8b, 8c) is moved, **characterised in that** said slotting tool (8, 8b, 8c) is inclined in the direction in which said slotting tool (8, 8b, 8c) is moved so that the angle formed between the front or rear surface (84, 85) of the cutting edge region (82) and the surface of the solar cell to be processed is in a range from 50 degrees to 80 degrees.

2. The method for slotting an integrated thin film solar cell according to Claim 1, wherein slotting is carried out on layers that include at least a light absorbing layer on an integrated thin film solar cell substrate (W).

3. The method for slotting an integrated thin film solar cell according to Claim 2, wherein the integrated thin film solar cell substrate (W) is an integrated thin film solar cell substrate before the formation of a transparent electrode layer.

4. A slotting tool (8, 8a, 8b), comprising: a body (81) in rod form; and a cutting edge region (82) in rectangular parallelepiped form formed at a tip of the body, wherein said cutting edge region (82) is formed of five planes: a rectangular bottom (83) surrounded by a pair of short sides and a pair of long sides; front and rear surfaces (84, 85) rising at a right angle relative to the bottom (83) from the two short sides of the bottom; and left and right sides (88, 89) rising at a right angle relative to the bottom (83) from the two long sides of the bottom (83),
cutting edges (93, 94) in the longitudinal direction are formed at the corner between the front surface (84) and the right side (89) as well as at the corner between the front surface (84) and the left side (88),
a cutting edge (95) in the lateral direction is formed at the corner between the bottom (83) and the front surface (84), **characterised in that** the corner between the bottom (83) and the right side (89) as well as the corner between the bottom (83) and the left side (88) are rounded.

5. The slotting tool (8, 8a, 8b) according to Claim 4, wherein the corner between the bottom (83) and the front surface (84) has an inclined surface (90).

6. The slotting tool (8, 8a, 8b) according to Claim 5, wherein the angle between the inclined surface (90) and the bottom (83) is in a range from 10 degrees to 40 degrees.

7. The slotting tool (8, 8a, 8b) according to Claim 4, wherein more cutting edges (97, 98) in the longitudinal direction are formed at the corner between the rear surface (85) and the right side (89) as well as at the corner between the rear surface (85) and the left side (88), and at the same time another cutting edge (99) in the lateral direction is formed at the corner between the rear surface (85) and the bottom (83).

8. The slotting tool (8, 8a, 8b) according to Claim 7, wherein the corner between the bottom (83) and the rear surface (85) has an inclined surface (96).

9. A scribing device (SC), **characterized by** comprising: the slotting tool (8, 8a, 8b) according to any of Claims 4 to 8; a table on which a solar cell substrate (W) is mounted; and a scribing head (9) with which said solar cell substrate (W) is scribed in such a state that the bottom of said slotting tool (8, 8a, 8b) is inclined relative to said solar cell substrate.

## Patentansprüche

1. Verfahren zum Schlitzen einer integrierten Dünnfilmsolarzelle, gemäß dem ein Schlitzwerkzeug (8, 8a, 8b) über ein integriertes Dünnfilmsolarzellensubstrat (W) entlang einer zu ritzenden Linie auf dem Solarzellensubstrat (W) mit der Schnittkante (86, 87) des Schlitzwerkzeugs (8, 8b, 8c) gegen das Solarzellensubstrat (W) so gedrückt bewegt wird, dass eine Ritzlinie auf der Solarzelle erzeugt wird, wobei
das Schlitzwerkzeug (8, 8b, 8c) umfasst: einen Körper (81) in Stangenform; und einen Schnittkantenbereich (82), der an einer Spitze des Körpers ausgebildet ist, wobei der Schnittkantenbereich (82) aus einem langen, rechteckigen Boden (83) einer vorderen Oberfläche (84) und einer rückwärtigen Oberfläche (85) ausgebildet ist, die von den kurzen Seiten des Bodens (83) ansteigen, und einem Paar Seiten, linken und rechten Seiten (88, 89), die in einem rechten Winkel von den langen Seiten des Bodens (83) ansteigen und die zueinander parallel liegen, und die Ecke (93, 94, 95, 97, 98, 99) die aus entweder einer Vorder- oder einer Rückseite und dem Boden (83) ausgebildet ist, als Schnittkante (86, 87) verwendet ist, und
die lange Achse des rechteckigen Bodens (83) in der Richtung liegt, in der das Schlitzwerkzeug (8, 8b, 8c) bewegt wird,
**dadurch gekennzeichnet, dass**
das Schlitzwerkzeug (8, 8b, 8c) in der Richtung geneigt ist, in die das Schlitzwerkzeug (8, 8b, 8c) so bewegt wird, dass der zwischen der vorderen oder rückwärtigen Oberfläche (84, 85) des Schnittkantenbereichs (82) und der zu bearbeitenden Oberfläche der Solarzelle ausgebildete Winkel in einem Bereich von 50 Grad bis 80 Grad liegt.

2. Verfahren zum Schlitzen einer integrierten Dünnfilmsolarzelle nach Anspruch 1, wobei das Schlitzen auf Schichten ausgeführt wird, wie zumindest eine lichtabsorbierende Schicht auf einem integrierten Dünnschichtsolarzellensubstrat (W) haben.

3. Verfahren zum Schlitzen einer integrierten Dünnfilmsolarzelle nach Anspruch 2, wobei das integrierte Dünnfilmsolarzellensubstrat (W) ein integriertes Dünnfilmsolarzellensubstrat vor der Ausbildung einer transparenten Elektrodenschicht ist.

4. Schlitzwerkzeug (8, 8a, 8b) mit: einem Körper (81) in Stangenform; und einem Schnittkantenbereich (82) in Form eines rechteckigen Parallelepipeds, das an einer Spitze des Körpers ausgebildet ist, wobei
der Schnittkantenbereich (82) aus fünf Ebenen ausgebildet ist: einem rechteckigen Boden (83), der durch ein Paar kurze Seiten und ein Paar lange Seiten umgeben ist; vordere und rückwärtige Oberflächen (84, 85), die mit einem rechten Winkel relativ zu dem Boden (83) von den zwei kurzen Seiten des Bodens ansteigen; und linke und rechte Seiten (88, 89), die mit einem rechten Winkel relativ zu dem Boden (83) von den zwei langen Seiten des Bodens (83) ansteigen,
Schnittkanten (93, 94) in der Längsrichtung an der Ecke zwischen der vorderen Oberfläche (84) und der rechten Seite (89), wie auch an der Ecke zwischen der vorderen Oberfläche (84) und der linken Seite (88) ausgebildet sind,
eine Schnittkante (95) in der seitlichen Richtung an der Ecke zwischen dem Boden (83) und der vorderen Oberfläche (84) ausgebildet ist,
**dadurch gekennzeichnet, dass**
die Ecke zwischen dem Boden (83) und der rechten Seite (89) wie auch die Ecke zwischen dem Boden (83) und der linken Seite (88) abgerundet sind.

5. Schlitzwerkzeug (8, 8a, 8b) nach Anspruch 4, wobei die Ecke zwischen dem Boden (83) und der vorderen Oberfläche (84) eine geneigte Oberfläche (90) aufweist.

6. Schlitzwerkzeug (8, 8a, 8b) nach Anspruch 5, wobei der Winkel zwischen der geneigten Oberfläche (90) und dem Boden (83) in einem Bereich von 10 Grad bis 40 Grad liegt.

7. Schlitzwerkzeug (8, 8a, 8b) nach Anspruch 4, wobei mehr Schnittkanten (97, 98) in der Längsrichtung an der Ecke zwischen der rückwärtigen Oberfläche (85) und der rechten Seite (89), wie auch an der Ecke zwischen der rückwärtigen Oberfläche (85) und der linken Seite (88) ausgebildet sind, und zu der selben Zeit eine andere Schnittkante (99) in der seitlichen Richtung an der Ecke zwischen der rückwärtigen Oberfläche (85) und dem Boden (83) ausgebildet ist.

8. Schlitzwerkzeug (8, 8a, 8b) nach Anspruch 7, wobei die Ecke zwischen dem Boden (83) und der rückwärtigen Oberfläche (85) eine geneigte Oberfläche (96) aufweist.

9. Ritzgerät (SC), **gekennzeichnet durch** Umfassen von: dem Schlitzwerkzeug (8, 8a, 8b) nach einem der Ansprüche 4 bis 8, einem Tisch, auf dem ein Solarzellensubstrat (W) montiert ist; und einem Schreibkopf (9), mit dem das Solarzellensubstrat (W) in einem derartigen Zustand geritzt wird, dass der Boden des Schlitzwerkzeugs (8, 8a, 8b) relativ zu dem Solarzellensubstrat geneigt ist.

## Revendications

1. Procédé pour rainurer une cellule solaire à film mince intégré, selon lequel un outil de rainurage (8, 8a, 8b) est déplacé sur un substrat de cellule solaire à film mince intégré (W) le long d'une ligne à tracer sur ledit substrat de cellule solaire (W), avec l'arête de coupe (86, 87) de l'outil de rainurage (8, 8b, 8c) qui est comprimée contre ledit substrat de cellule solaire (W), de sorte qu'une ligne de tracé est créée sur ladite cellule solaire, dans lequel :
ledit outil de rainurage (8, 8b, 8c) comprend : un corps (81) en forme de tige ; et une région d'arête de coupe (82) formée au niveau d'une pointe du corps dans lequel la région d'arête de coupe (82) est formée avec un long fond rectangulaire (83), une surface avant (84) et une surface arrière (85) qui remontent à partir des côtés courts du fond (83), et une paire de côtés, des côtés gauche et droit (88, 89), qui remontent, en angle droit, à partir des côtés longs du fond (83) et sont parallèles entre eux, et le coin (93, 94, 95, 97, 98, 99) formé avec un côté avant ou arrière et le fond (83) est utilisé en tant qu'arête de coupe (86, 87), et
l'axe long du fond rectangulaire (83) est dans la direction dans laquelle ledit outil de rainurage (8, 8b, 8c) est déplacé, **caractérisé en ce que** ledit outil de rainurage (8, 8b, 8c) est incliné dans la direction dans laquelle ledit outil de rainurage (8, 8b, 8c) est déplacé de sorte que l'angle formé entre la surface avant ou arrière (84, 85) de la région d'arête de coupe (82) et la surface de la cellule solaire à traiter, est dans une plage de 50 degrés à 80 degrés.

2. Procédé pour rainurer une cellule solaire à film mince intégré selon la revendication 1, dans lequel le rainurage est réalisé sur des couches qui comprennent au moins une couche d'absorption de lumière sur un substrat de cellule solaire à film mince intégré (W).

3. Procédé pour rainurer une cellule solaire à film mince intégré selon la revendication 2, dans lequel le substrat de cellule solaire à film mince intégré (W) est un substrat de cellule solaire à film mince intégré avant la déformation d'une couche d'électrode transparente.

4. Outil de rainurage (8, 8a, 8b) comprenant : un corps (81) en forme de tige ; et une région d'arête de coupe (82) en forme de parallélépipède rectangle formée au niveau d'une pointe du corps, dans lequel :
ladite région d'arête de coupe (82) est formée avec cinq plans : un fond rectangulaire (83) entouré par une paire de côtés courts et une paire de côtés longs ; des surfaces avant et arrière (84, 85) remontant en angle droit par rapport au fond (83) à partir des deux côtés courts du fond ; et des côtés gauche et droit (88, 89) remontant en angle droit par rapport au fond (83) à partir des deux côtés longs du fond (83),
des arêtes de coupe (93, 94) dans la direction longitudinale sont formées au niveau du coin entre la surface avant (84) et le côté droit (89) ainsi qu'au niveau du coin entre la surface avant (84) et le côté gauche (88),
une arête de coupe (95) dans la direction latérale est formée au niveau du coin entre le fond (83) et la surface avant (84), **caractérisé en ce que** :
le coin entre le fond (83) et le côté droit (89) ainsi que le coin entre le fond (83) et le côté gauche (88) sont arrondis.

5. Outil de rainurage (8, 8a, 8b) selon la revendication 4, dans lequel le coin entre le fond (83) et la surface avant (84) a une surface inclinée (90).

6. Outil de rainurage (8, 8a, 8b) selon la revendication 5, dans lequel l'angle entre la surface inclinée (90) et le fond (83) est dans une plage de 10 degrés à 40 degrés.

7. Outil de rainurage (8, 8a, 8b) selon la revendication 4, dans lequel on forme plus d'arêtes de coupe (97, 98) dans la direction longitudinale au niveau du coin entre la surface arrière (85) et le côté droit (89) ainsi qu'au niveau du coin entre la surface arrière (85) et le côté gauche (88) et en même temps, on forme une autre arête de coupe (99) dans la direction latérale au niveau du coin entre la surface arrière (85) et le fond (83).

8. Outil de rainurage (8, 8a, 8b) selon la revendication 7, dans lequel le coin entre le fond (83) et la surface arrière (85) a une surface inclinée (96).

9. Dispositif de traçage (SC), **caractérisé en ce qu'**il comprend : l'outil de rainurage (8, 8a, 8b) selon l'une quelconque des revendication 4 à 8 ; une table sur laquelle un substrat de cellule solaire (W) est monté ; et une tête de traçage (9) avec laquelle ledit substrat de cellule solaire (W) est tracé dans un état dans lequel le fond dudit outil de rainurage (8, 8a, 8b) est incliné par rapport audit substrat de cellule solaire.
